# EUROPEAN PATENT APPLICATION

(11) **EP 3 790 365 A1**
(43) Date of publication of application: **10.03.2021**
(21) Application number: 19195368.6
(22) Date of filing: 04.09.2019
(51) Int. Cl.: H05K 1/18, H05K 3/00

(54) **COMPONENT CARRIER AND METHOD OF MANUFACTURING THE SAME**

(71) Applicant: AT & S Austria Technologie & Systemtechnik Aktiengesellschaft, 8700 Leoben-Hinterberg (AT)
(72) Inventor: Stahr, Johannes, 8605 St. Lorenzen im Mürztal (AT); Zluc, Andreas, 8700 Leoben (AT); Moitzi, Heinz, 8740 Zeltweg (AT)
(74) Representative: Dilg, Haeusler, Schindelmann Patentanwaltsgesellschaft mbH

(57) **Abstract**

The present invention relates to a component carrier (1) comprising a stack (2) comprising at least one electrically insulating layer structure and/or at least one electrically conductive layer structure, a component (3) embedded in the stack (2) and having a curved surface portion (4, 5), and a conductive contact element (6, 7, 8, 9) in contact with the curved surface portion (4, 5) of the embedded component (3). The present invention also relates to a method of manufacturing such a component carrier (1).

## Description

The invention relates to a component carrier and to a method of manufacturing the same.

A conventional component carrier comprises a stack having an electrically insulating layer structure and an electrically conductive layer. A component is surface-mounted on or embedded in the stack. In the latter case, connections to the embedded component extend through at least a part of the stack. Due to the small dimensions and the corresponding small points of contact, the quality of the physical connections between the component and the conductive element extending through the stack are limited both in terms of stability and conductivity.

It is an object of the invention to provide a component carrier and a method of manufacturing the same, by which both stability and conductivity of connections to an embedded component is improved.

This object is achieved by the subject matters of the independent claims. Further advantageous embodiments are set forth in the dependent claims.

According to an exemplary embodiment of the invention, a component carrier comprises a stack comprising at least one electrically insulating layer structure and/or at least one electrically conductive layer structure, a component embedded in the stack and having a curved surface portion, and a conductive contact element in contact with the curved surface portion of the embedded component.

According to another exemplary embodiment of the invention, a method of manufacturing a component carrier comprises providing a stack comprising at least one electrically insulating layer structure and/or at least one electrically conductive layer structure, embedding a component in the stack, the component having at least a curved surface portion, forming a recess in the stack to thereby expose at least part of the curved surface portion of the component, and filling the recess at least partially with conductive material to thereby form a conductive contact element extending up to the curved surface portion of the component.

In the context of the present application, the term "curved surface portion" may in particular refer to a non-flat or non-planar surface portion, i.e. a surface portion which has a curved rather than linear profile.

The component carrier with the above-mentioned configuration exhibits improved quality of the connection between the embedded component and the conductive contact element, in particular in terms of stability and conductivity. In particular, the curved surface of the embedded component provides an increased contact area in comparison to a customary flat surface. Thus, the component carrier is robust and capable of conducting increased amounts of heat and/or electric current away from and to the embedded component.

In the following, further exemplary embodiments of the present invention will be explained.

According to an exemplary embodiment, the conductive contact element is an electrically and/or thermally conductive contact element. In other words, the conductive contact element may be an electrically conductive contact element capable of conducting electrical current, it may be a thermally conductive contact element capable of conducting heat, or it may be an electrically and thermally conductive contact element capable of conducting both electrical current and heat.

According to an exemplary embodiment, the curved surface portion is convex. The convex surface portion provides an increased surface area (compared to a flat surface) and allows for reliable and efficient contact with the conductive contact element.

According to an exemplary embodiment, the curved surface portion is concave. The concave surface portion provides an increased surface area (compared to a flat surface) and allows for reliable and efficient contact with the conductive contact element.

This form lock fixing in the PCB enables higher mechanical bond strength.

According to an exemplary embodiment, the curved surface portion corresponds to an electric connection area of the component. In other words, the curved surface portion acts as a terminal for electrically connecting the component with other circuitry.

According to an exemplary embodiment, the component is a passive component.

According to an exemplary embodiment, the passive component is an ohmic resistance or a capacitor. The component may in particular form part of a filter circuit.

According to an exemplary embodiment, an outermost electrically conductive layer structure of the stack has a through-hole through which the contact element extends, wherein the contact element has a lateral extension being larger than a diameter of the through-hole. In other words, the contact element extends through the through-hole in the outermost layer structure and towards the curved surface portion. Furthermore, the lateral extension of at least a part of the contact element, in particular the part in contact with the curved surface portion of the embedded component, is larger than the diameter of the through-hole. Accordingly, the contact element forms an anchor-like structure below the outermost layer structure and thus has a further increased surface area contacting the curved surface portion of the component.

According to an exemplary embodiment, both opposing main surfaces of the embedded component are contacted by a respective conductive contact element for providing electrical and/or thermal conduction between two opposing contact elements via the curved portion of the component. This exemplary embodiment is particularly useful in conjunction with four-terminal sensing of component impedance as the current can be supplied to the terminals on one side of the component while the voltage is measured across the terminals on the opposing side of the component.

According to an exemplary embodiment, the component carrier comprises at least one of the following features: the component carrier comprises at least one component being surface mounted on and/or embedded in the component carrier, wherein the at least one component is in particular selected from a group consisting of a power semiconductor component, in particular a power transistor chip, an electronic component, an electrically non-conductive and/or electrically conductive inlay, a heat transfer unit, a light guiding element, an energy harvesting unit, an active electronic component, a passive electronic component, an electronic chip, a storage device, a filter, an integrated circuit, a signal processing component, a power management component, an optoelectronic interface element, a voltage converter, a cryptographic component, a transmitter and/or receiver, an electromechanical transducer, an actuator, a microelectromechanical system, a microprocessor, a capacitor, a resistor, an inductance, an accumulator, a switch, a camera, an antenna, a magnetic element, a further component carrier, and a logic chip; wherein at least one of the electrically conductive layer structures of the component carrier comprises at least one of the group consisting of copper, aluminum, nickel, silver, gold, palladium, and tungsten, any of the mentioned materials being optionally coated with supra-conductive material such as graphene; wherein the electrically insulating layer structure comprises at least one of the group consisting of resin, in particular reinforced or non-reinforced resin, for instance epoxy resin or Bismaleimide-Triazine resin, FR-4, FR-5, cyanate ester, polyphenylene derivate, glass, prepreg material, polyimide, polyamide, liquid crystal polymer, epoxy-based build-up film, polytetrafluoroethylene, a ceramic, and a metal oxide; wherein the component carrier is shaped as a plate; wherein the component carrier is configured as one of the group consisting of a printed circuit board, a substrate, and an interposer; wherein the component carrier is configured as a laminate-type component carrier.

According to an exemplary embodiment of the method, the recess is formed using a laser.

According to an exemplary embodiment of the method, the laser is a CO₂ laser or a UV laser.

According to an exemplary embodiment of the method, the recess is formed by laser drilling so that reflection of the laser beam at the exposed curved surface portion forms pockets extending laterally beyond a through-hole in an outermost patterned electrically conductive layer structure. Accordingly, once the laser has drilled far enough through the stack to expose the curved surface portion, the curved surface portion reflects the laser beam laterally such that pockets are formed, resulting in the recess having a larger lateral extension than the through-hole. Thus, when the recess is filled with conductive material, the resulting conductive contact element forms an anchor-like structure above the curved surface portion of the component.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact. The term "layer structure" may particularly denote a continuous layer, a patterned layer or a plurality of nonconsecutive islands within a common plane.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a in relation to a PCB comparably small component carrier onto which one or more components may be mounted and that acts as a connection medium between chip(s) and a further PCB. More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) or a photoimageable or dry-etchable organic material like epoxy-based build-up material (such as epoxy-based build-up film) or polymer compounds like polyimide, polybenzoxazole, or benzocyclobutene.

In an embodiment, the at least one electrically insulating layer structure comprises at least one of the group consisting of resin (such as reinforced or non-reinforced resins, for instance epoxy resin or bismaleimide-triazine resin), cyanate ester, polyphenylene derivate, glass (in particular glass fibers, multilayer glass, glass-like materials), prepreg material (such as FR-4 or FR-5), polyimide, polyamide, liquid crystal polymer (LCP), epoxy-based build-up film, polytetrafluoroethylene (teflon), a ceramic, and a metal oxide. Reinforcing materials such as webs, fibers or spheres, for example made of glass (multilayer glass) may be used as well. Although prepreg particularly FR4 are usually preferred for rigid PCBs, other materials in particular epoxy-based build-up film or photoimageable dielectric material may be used as well. For high frequency applications, high-frequency materials such as polytetrafluoroethylene, liquid crystal polymer and/or cyanate ester resins, low temperature cofired ceramics (LTCC) or other low, very low or ultra-low DK materials may be implemented in the component carrier as electrically insulating layer structure.

In an embodiment, the at least one electrically conductive layer structure comprises at least one of the group consisting of copper, aluminum, nickel, silver, gold, palladium, and tungsten. Although copper is usually preferred, other materials or coated versions thereof are possible as well, in particular coated with supra-conductive material such as graphene.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layer structures or component carrier.

In particular, an electrically insulating solder resist may be applied to one or both opposing main surfaces of the layer stack or component carrier in terms of surface treatment. For instance, it is possible to form such as solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are OSP (Organic Solderability Preservative), Electroless Nickel Immersion Gold (ENIG), gold (in particular Hard Gold), chemical tin, nickel-gold, nickel-palladium, etc.

The aspects defined above and further aspects of the invention are apparent from the examples of embodiment to be described hereinafter and are explained with reference to these examples of embodiment.
Figure 1 illustrates a component carrier according to an exemplary embodiment of the invention.
Figure 2 illustrates improved heat dissipation provided by the component carrier shown in Figure 1.
Figure 3 illustrates a sequence of steps during manufacture of a component carrier according to an exemplary embodiment of the invention.

The illustrations in the drawings are schematic. In different drawings, similar or identical elements are provided with the same reference signs.

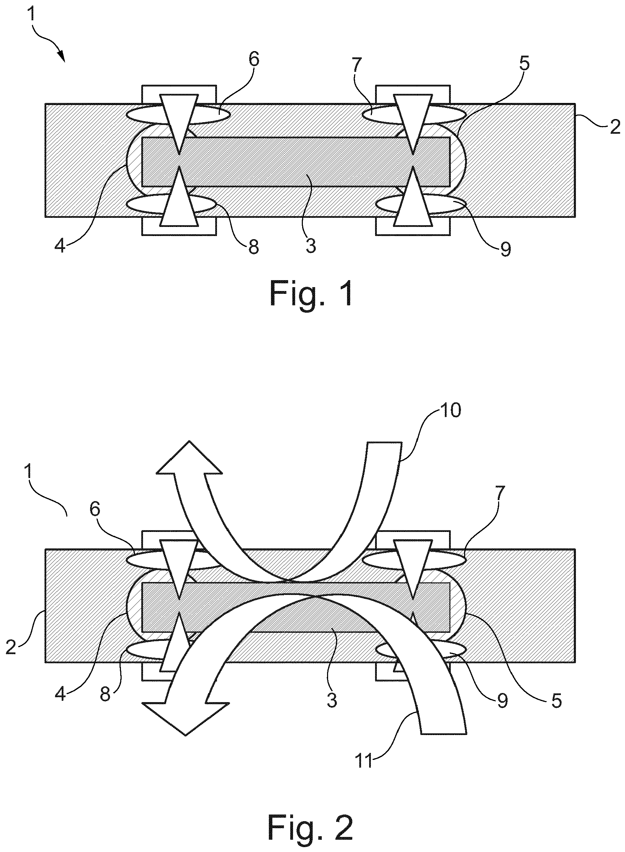

**Figure 1** illustrates a component carrier 1 according to an exemplary embodiment of the invention.

The component carrier 1 may be shaped as a plate. The component carrier 1 may be configured as one of the group consisting of a printed circuit board, a substrate, and an interposer. The component carrier 1 may be configured as a laminate-type component carrier.

The component carrier 1 comprises a stack 2 comprising at least one electrically insulating layer structure (not shown in detail) and/or at least one electrically conductive layer structure (not shown in detail).

The at least one electrically insulating layer structure of the component carrier 1 may comprise at least one of the group consisting of resin, in particular reinforced or non-reinforced resin, for instance epoxy resin or bismaleimide-triazine resin, FR-4, FR-5, cyanate ester, polyphenylene derivate, glass, prepreg material, polyimide, polyamide, liquid crystal polymer, epoxy-based build-up film, polytetrafluoroethylene, a ceramic, and a metal oxide.

The at least one electrically conductive layer structure of the component carrier 1 may comprise at least one of the group consisting of copper, aluminum, nickel, silver, gold, palladium, and tungsten, any of the mentioned materials being optionally coated with supra-conductive material such as graphene.

The component carrier 1 further comprises a component 3 embedded in the stack and having curved surface portions 4, 5. As shown, the curved surface portions 4, 5 are convex. In other embodiments, the curved surface portions may be concave. The component 3 is preferably a passive component, such as a resistor or a capacitor forming part of or constituting a filter. The curved surface portions 4, 5 may constitute electric and/or thermal connection areas of the component 3.

The component carrier 1 further comprises conductive contact elements 6, 7, 8, 9 extending through the stack 2 such that they are in contact with the curved surface portions 4, 5 of the component 3. The conductive contact elements 6, 7, 8, 9 are thermally and/or electrically conductive and may thus serve to conduct electrical current and/or heat to and away from the component 3. The conductive contact elements 6, 7, 8, 9 have an anchor-like shape providing a parabolic contact surface with the curved surface portions 4, 5.

The component carrier 1 with the above mentioned configuration exhibits improved contact stability and (thermal and electrical) conductivity between the contacting areas 4, 5 of the component and the conductive contact elements 6, 7, 8, 9. This is indicated in **Figure 2** by arrows 10 and 11 which show paths of heat dissipation from the component 3 within the stack 2 of the component carrier 1. The improvement in heat conductivity as compared to standard via connections is around 30%.

In addition to the improved thermal properties, the component carrier 1 with conductive contact elements 6, 7, 8, 9 on both sides of the structure allows for four-terminal sensing when the component 3 is a resistor or other impedance.

It is explicitly stated that other embodiments may have conductive contact elements on only one side of the component carrier. In other words, some embodiments may only have conductive contact elements 6, 7 while other embodiments may only have conductive contact elements 8, 9 shown in Figures 1 and 2.

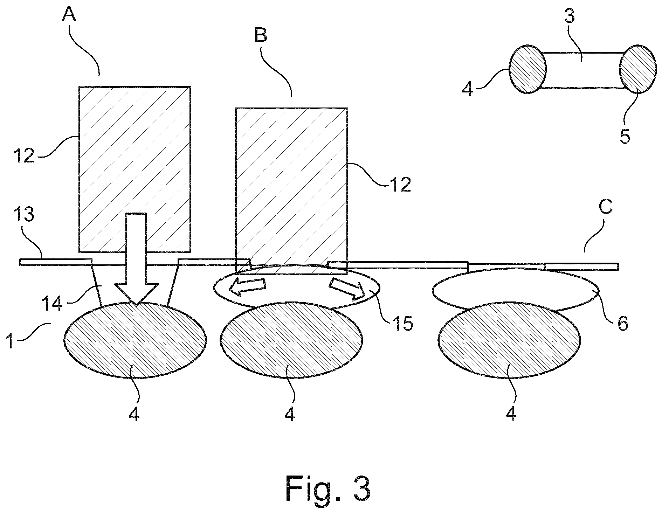

**Figure 3** illustrates a sequence of steps or states A, B, C during manufacture of a component carrier 1 according to an exemplary embodiment of the invention. In step A, a laser 12, such as a CO₂ laser or a UV laser, is operated to drill a hole through an outermost conductive layer structure 13 of the stack of the component carrier 1 and thereby form a recess 14 above the curved surface portion 4 of the embedded component in the stack. Once the hole 14 is deep enough to expose the curved surface 4 of the embedded component 3, the laser beam will be reflected by the exposed curved surface 4. This leads to a lateral extension of the recess as shown in step B such that the resulting recess 15 has a larger lateral extension than the diameter of the hole initially drilled through the outermost conductive layer structure 13. Then, in step C, conductive material is filled into the recess to form conductive contact element 6. As shown, the contact surface between the curved surface portion 4 and the conductive contact element 6 has a parabolic shape. This provides a stable contact and a large contact surface area.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible, which use the solutions shown and the principle according to the invention even in the case of fundamentally different embodiments.

## Claims

1. A component carrier (1), comprising:
a stack (2) comprising at least one electrically insulating layer structure and/or at least one electrically conductive layer structure;
a component (3) embedded in the stack (2) and having a curved surface portion (4, 5); and
a conductive contact element (6, 7, 8, 9) in contact with the curved surface portion (4, 5) of the embedded component (3).

2. The component carrier (1) according to the preceding claim, wherein the conductive contact element (6, 7, 8, 9) is an electrically and/or thermally conductive contact element.

3. The component carrier (1) according to any one of the preceding claims, wherein the curved surface portion (4, 5) is convex.

4. The component carrier (1) according to any one of the preceding claims, wherein the curved surface portion is concave.

5. The component carrier (1) according to any one of the preceding claims, wherein the curved surface portion (4, 5) corresponds to an electric connection area of the component (3).

6. The component carrier (1) according to any one of the preceding claims, wherein the component (3) is a passive component.

7. The component carrier (1) according to the preceding claim, wherein the passive component is an ohmic resistance or a capacitor.

8. The component carrier (1) according to any one of the preceding claims, wherein an outermost electrically conductive layer structure of the stack has a through-hole through which the contact element extends, wherein the contact element has a lateral extension being larger than a diameter of the through-hole.

9. The component carrier (1) according to any one of the preceding claims, wherein both opposing main surfaces of the embedded component are contacted by a respective conductive contact element for providing electrical and/or thermal conduction between two opposing contact elements via the curved portion of the component.

10. The component carrier (1) according to any one of the preceding claims, comprising at least one of the following features:
the component carrier (1) comprises at least one component (3) being surface mounted on and/or embedded in the component carrier, wherein the at least one component is in particular selected from a group consisting of a power semiconductor component, in particular a power transistor chip, an electronic component, an electrically non-conductive and/or electrically conductive inlay, a heat transfer unit, a light guiding element, an energy harvesting unit, an active electronic component, a passive electronic component, an electronic chip, a storage device, a filter, an integrated circuit, a signal processing component, a power management component, an optoelectronic interface element, a voltage converter, a cryptographic component, a transmitter and/or receiver, an electromechanical transducer, an actuator, a microelectromechanical system, a microprocessor, a capacitor, a resistor, an inductance, an accumulator, a switch, a camera, an antenna, a magnetic element, a further component carrier, and a logic chip;
wherein at least one of the electrically conductive layer structures of the component carrier comprises at least one of the group consisting of copper, aluminum, nickel, silver, gold, palladium, and tungsten, any of the mentioned materials being optionally coated with supra-conductive material such as graphene;
wherein the electrically insulating layer structure comprises at least one of the group consisting of resin, in particular reinforced or non-reinforced resin, for instance epoxy resin or Bismaleimide-Triazine resin, FR-4, FR-5, cyanate ester, polyphenylene derivate, glass, prepreg material, polyimide, polyamide, liquid crystal polymer, epoxy-based build-up film, polytetrafluoroethylene, a ceramic, and a metal oxide;
wherein the component carrier (1) is shaped as a plate;
wherein the component carrier (1) is configured as one of the group consisting of a printed circuit board, a substrate, and an interposer;
wherein the component carrier (1) is configured as a laminate-type component carrier.

11. A method of manufacturing a component carrier (1), wherein the method comprises:
providing a stack (2) comprising at least one electrically insulating layer structure and/or at least one electrically conductive layer structure (13);
embedding a component (3) in the stack, the component having at least a curved surface portion (4, 5);
forming a recess (14, 15) in the stack to thereby expose at least part of the curved surface portion (4, 5) of the component (3); and
filling the recess (14, 15) at least partially with conductive material to thereby form a conductive contact element (6, 7, 8, 9) extending up to the curved surface portion (4, 5) of the component (3).

12. The method according to the preceding claim, wherein the recess (14, 15) is formed using a laser (12).

13. The method according to the preceding claim, wherein the laser (12) is a CO₂ laser or a UV laser.

14. The method according to any one of claims 11 to 13, wherein the recess (14, 15) is formed by laser drilling so that reflection of the laser beam at the exposed curved surface portion (4, 5) forms pockets extending laterally beyond a through-hole in an outermost patterned electrically conductive layer structure (13).

## Amended claims

### Amended claims in accordance with Rule 137(2) EPC.

1. A component carrier (1), comprising:
a stack (2) comprising at least one electrically insulating layer structure and/or at least one electrically conductive layer structure;
a component (3) embedded in the stack (2) and having a curved surface portion (4, 5); and
a conductive contact element (6, 7, 8, 9) in contact with the curved surface portion (4, 5) of the embedded component (3),
wherein an outermost electrically conductive layer structure of the stack has a through-hole through which the contact element extends, wherein the contact element has a lateral extension being larger than a diameter of the through-hole.

2. The component carrier (1) according to the preceding claim, wherein the conductive contact element (6, 7, 8, 9) is an electrically and/or thermally conductive contact element.

3. The component carrier (1) according to any one of the preceding claims, wherein the curved surface portion (4, 5) is convex.

4. The component carrier (1) according to any one of the preceding claims, wherein the curved surface portion is concave.

5. The component carrier (1) according to any one of the preceding claims, wherein the curved surface portion (4, 5) corresponds to an electric connection area of the component (3).

6. The component carrier (1) according to any one of the preceding claims, wherein the component (3) is a passive component.

7. The component carrier (1) according to the preceding claim, wherein the passive component is an ohmic resistance or a capacitor.

8. The component carrier (1) according to any one of the preceding claims, wherein both opposing main surfaces of the embedded component are contacted by a respective conductive contact element for providing electrical and/or thermal conduction between two opposing contact elements via the curved portion of the component.

9. The component carrier (1) according to any one of the preceding claims, comprising at least one of the following features:
the component carrier (1) comprises at least one component (3) being surface mounted on and/or embedded in the component carrier, wherein the at least one component is in particular selected from a group consisting of a power semiconductor component, in particular a power transistor chip, an electronic component, an electrically non-conductive and/or electrically conductive inlay, a heat transfer unit, a light guiding element, an energy harvesting unit, an active electronic component, a passive electronic component, an electronic chip, a storage device, a filter, an integrated circuit, a signal processing component, a power management component, an optoelectronic interface element, a voltage converter, a cryptographic component, a transmitter and/or receiver, an electromechanical transducer, an actuator, a microelectromechanical system, a microprocessor, a capacitor, a resistor, an inductance, an accumulator, a switch, a camera, an antenna, a magnetic element, a further component carrier, and a logic chip;
wherein at least one of the electrically conductive layer structures of the component carrier comprises at least one of the group consisting of copper, aluminum, nickel, silver, gold, palladium, and tungsten, any of the mentioned materials being optionally coated with supra-conductive material such as graphene;
wherein the electrically insulating layer structure comprises at least one of the group consisting of resin, in particular reinforced or non-reinforced resin, for instance epoxy resin or Bismaleimide-Triazine resin, FR-4, FR-5, cyanate ester, polyphenylene derivate, glass, prepreg material, polyimide, polyamide, liquid crystal polymer, epoxy-based build-up film, polytetrafluoroethylene, a ceramic, and a metal oxide;
wherein the component carrier (1) is shaped as a plate;
wherein the component carrier (1) is configured as one of the group consisting of a printed circuit board, a substrate, and an interposer;
wherein the component carrier (1) is configured as a laminate-type component carrier.

10. A method of manufacturing a component carrier (1), wherein the method comprises:
providing a stack (2) comprising at least one electrically insulating layer structure and/or at least one electrically conductive layer structure (13);
embedding a component (3) in the stack, the component having at least a curved surface portion (4, 5);
forming a recess (14, 15) in the stack to thereby expose at least part of the curved surface portion (4, 5) of the component (3); and
filling the recess (14, 15) at least partially with conductive material to thereby form a conductive contact element (6, 7, 8, 9) extending up to the curved surface portion (4, 5) of the component (3),
wherein the recess (14, 15) is formed by laser drilling so that reflection of the laser beam at the exposed curved surface portion (4, 5) forms pockets extending laterally beyond a through-hole in an outermost patterned electrically conductive layer structure (13).

11. The method according to the preceding claim, wherein the recess (14, 15) is formed using a laser (12).

12. The method according to the preceding claim, wherein the laser (12) is a CO₂ laser or a UV laser.
